(19) Europäisches Patentamt
European Patent Office
Office européen des brevets

(11) **EP 3 502 716 B1**

(12) **FASCICULE DE BREVET EUROPEEN**

(45) Date de publication et mention de la délivrance du brevet:
**12.04.2023 Bulletin 2023/15**

(21) Numéro de dépôt: **18212271.3**

(22) Date de dépôt: **13.12.2018**

(51) Classification Internationale des Brevets (IPC):
**G01R 21/08** $^{(2006.01)}$   **G01R 35/00** $^{(2006.01)}$
G01R 21/133 $^{(2006.01)}$   H02S 50/00 $^{(2014.01)}$

(52) Classification Coopérative des Brevets (CPC):
**G01R 21/08; G01R 35/005; H02S 50/00;**
G01R 21/133; Y02E 10/50

(54) **PROCÉDÉ ET DISPOSITIF D'ESTIMATION D'UNE PRODUCTION D'UNE INSTALLATION PHOTOVOLTAÏQUE**

VERFAHREN UND VORRICHTUNG ZUM ABSCHÄTZEN DER PRODUKTION EINER FOTOVOLTAIKANLAGE

METHOD AND DEVICE FOR ESTIMATING PRODUCTION OF A PHOTOVOLTAIC SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2017 FR 1762898**

(43) Date de publication de la demande:
**26.06.2019 Bulletin 2019/26**

(73) Titulaire: **Electricité de France**
**75008 Paris (FR)**

(72) Inventeurs:
• **WIZNIEWSKI, David**
**77670 SAINT MAMMES (FR)**

• **DUPUIS, Julien**
**77590 BOIS LE ROI (FR)**
• **DUPEYRAT, PATRICK**
**77210 AVON (FR)**

(74) Mandataire: **Plasseraud IP**
**66, rue de la Chaussée d'Antin**
**75440 Paris Cedex 09 (FR)**

(56) Documents cités:
EP-A1- 2 660 943    EP-A1- 2 996 158
EP-A1- 3 016 277    EP-A2- 2 591 534
WO-A1-2016/107737    WO-A1-2017/152243
US-A1- 2014 012 427    US-A1- 2016 190 984
US-A1- 2017 090 004    US-B2- 9 520 623

**Description**

L'invention concerne le domaine des procédés d'estimation d'une production d'une installation photovoltaïque et un dispositif d'estimation d'une production d'une installation photovoltaïque.

Plus précisément, l'invention concerne un procédé et un dispositif pour l'estimation de la production d'une installation photovoltaïque par mesure d'un champ magnétique résultant autour du câble multiconducteur en sortie de l'onduleur de l'installation photovoltaïque.

Actuellement, il est relativement compliqué d'estimer la production d'une installation photovoltaïque. C'est pourtant une donnée utile pour analyser la performance d'une installation photovoltaïque, notamment dans le contexte énergétique actuel où l'autoconsommation prend une place importante.

En pratique, quelques onduleurs disposent d'une connectivité permettant d'obtenir l'estimation de la production de l'installation photovoltaïque à laquelle les onduleurs sont rattachés, mais ce n'est pas la norme.

Pour connaître la production d'une installation, il est possible de mettre en place des dispositifs de mesure spécifiques, tels que des compteurs électrique ou des pinces de courant. Ces solutions sont néanmoins coûteuses et nécessitent d'être mises en place par des techniciens qualifiés.

Plus précisément, le courant et la tension en sortie de l'onduleur sont mesurés. La mesure du courant est faite au moyen d'un capteur de courant de type tore ou pince de mesure. Le capteur de courant est positionné sur le conducteur de phase en sortie de l'onduleur. Ainsi, le conducteur ou le tableau électrique doit être manipulé pour permettre l'installation du capteur de courant. La pause du capteur nécessite donc des compétences en électricité. US 2017/090004 A1 décrit un procédé pour mesurer une puissance d'une installation photovoltaïque en utilisant un capteur ne nécessitant pas de compétence en électricité. Le capteur est un capteur de champ magnétique résultant, placé par exemple sur le câble en sortie de l'installation photovoltaïque. WO 2017/152243 A1 décrit un procédé pour déterminer une puissance délivrée dans un câble, où le champ magnétique résiduel produit par le câble est mesuré au moyen d'un capteur pouvant par exemple être positionné autour du câble isolé, en sortie de l'onduleur photovoltaïque.

La présente invention vient améliorer la situation.

A cet effet, elle propose un procédé, mis en oeuvre par des moyens informatiques, d'estimation d'une production d'une installation photovoltaïque par une mesure d'un champ magnétique résultant d'un câble multiconducteur en sortie d'un onduleur de l'installation photovoltaïque, le procédé comprenant :

-  une calibration comportant :

   ◦ une détermination d'un signal utile en tension en sortie de l'installation à partir de la mesure du champ magnétique résultant à un instant donné,

   ◦ une obtention d'une production courante de l'installation photovoltaïque au même instant donné,

   ◦ une détermination d'un coefficient de mise à l'échelle mettant en relation le signal utile en tension et la production de l'installation à l'instant donné, le coefficient de mise à l'échelle étant stocké en mémoire,

-  puis, l'estimation, à chaque instant, d'une production courante de l'installation photovoltaïque à partir du signal utile en tension en sortie de l'installation déterminé à chaque instant, et du coefficient de mise à l'échelle stocké en mémoire.

Grâce à ces dispositions, l'estimation de la production de l'installation photovoltaïque ne nécessite plus d'intervenir sur le circuit électrique de l'installation, puisque la production est estimée par mesure d'un champ magnétique résultant du câble multiconducteur en sortie de l'onduleur. Le câble multiconducteur comprend et isole à la fois la phase, le neutre et la terre. Ce câble est accessible directement dans toute installation photovoltaïque.

Selon une réalisation, la calibration comporte en outre une vérification du coefficient de mise à l'échelle, et, le cas échéant, une correction du coefficient de mise à l'échelle.

Ainsi, l'estimation de la production courante de l'installation photovoltaïque n'est pas faussée si le coefficient de mise à l'échelle déterminé lors de la calibration n'est pas correct.

Selon une réalisation, lors de la calibration, la production courante de l'installation photovoltaïque à l'instant donné est obtenue par un relevé d'une valeur de la production courante sur l'onduleur par un utilisateur à l'instant donné, la valeur étant saisie par l'utilisateur via une interface de communication connectée aux moyens informatiques.

De cette manière, la calibration par l'utilisateur est aisée puisque la valeur de la production courante de l'installation photovoltaïque peut être relevée directement sur l'onduleur lorsque c'est possible. L'utilisation de moyens connectés de communication permet en outre d'accélérer l'étape de calibration.

Selon une réalisation, lors de la calibration, la production courante de l'installation photovoltaïque à l'instant donné est obtenue par une modélisation de l'installation photovoltaïque à partir de données relatives à l'installation photovoltaïque, les données étant saisies par un utilisateur via une interface de communication connectée aux moyens informatiques.

Ainsi, à partir des caractéristiques connues de l'installation photovoltaïque, telles que la puissance-crête de l'installation, l'inclinaison, l'orientation des panneaux photovoltaïque, le type de panneaux etc., il est possible de déterminer par modélisation de l'installation la puissance courante à l'instant donné. Il est également possible de faire cette modélisation à partir de données météorologiques. Les données météorologiques comprennent par exemple le taux d'ensoleillement de l'installation, etc. Les données météorologiques peuvent être obtenues via une application informatique, un serveur informatique ou une base de données.

Selon une réalisation, lors de la calibration, la production courante de l'installation photovoltaïque à l'instant donné est obtenue au moyen d'un compteur électrique communicant connecté aux moyens informatiques.

Ainsi, la calibration est faite sans intervention de l'utilisateur, puisque le compteur communiquant est connecté aux moyens informatiques de l'installation. Cela permet également un échange de données fiable entre le compteur communiquant et l'installation.

Selon une réalisation, la production courante de l'installation photovoltaïque est, à chaque instant, communiquée à un utilisateur au moyen d'une interface de communication connectée aux moyens informatiques.

L'utilisateur peut dès lors suivre l'évolution de la production de son installation photovoltaïque, notamment s'il pratique l'autoconsommation.

Selon une réalisation, le procédé comprend en outre une détermination de présence d'un défaut de l'installation photovoltaïque par une comparaison entre une production de référence de l'installation photovoltaïque et la production courante de l'installation photovoltaïque.

Ainsi, en plus d'avoir accès à l'estimation de la production courante d'une installation photovoltaïque, l'utilisateur peut être averti de la présence d'un défaut sur l'installation photovoltaïque à tout moment. Cela permet notamment à l'utilisateur d'appréhender un éventuel dysfonctionnement de l'installation, ou de prévoir une prochaine réparation de l'installation photovoltaïque. De cette manière, l'utilisateur peut continuer à avoir accès à l'énergie fournie par son installation photovoltaïque.

Selon une réalisation, le procédé comprend en outre une détermination d'une variation entre une consommation électrique d'un utilisateur de l'installation photovoltaïque et la production courante de l'installation photovoltaïque, en cas de variation, l'émission d'un message à l'utilisateur au moyen d'une interface de communication connectée aux moyens informatiques.

Grâce à ces dispositions, l'utilisateur peut réguler sa consommation d'énergie en fonction de la production courante estimée de l'installation.

L'invention vise aussi un dispositif d'estimation d'une production d'une installation photovoltaïque par une mesure d'un champ magnétique résultant d'un câble multiconducteur en sortie d'un onduleur de l'installation photovoltaïque, le dispositif comprenant :

- un circuit de traitement configuré pour la mise en oeuvre du procédé selon l'invention.

Selon une réalisation, le dispositif comprend en outre au moins un capteur, apte à mesurer un champ magnétique résultant, le capteur étant de type à effet Hall.

Le capteur utilisé est simple d'installation et peut être installé par un utilisateur ne possédant pas de connaissance en électricité.

Selon une réalisation, le dispositif comprend en outre une interface de communication, reliée au circuit de traitement de manière sans-fil.

Ainsi, la communication entre le dispositif est l'utilisateur est possible, à tout instant.

On peut également prévoir une application Web, connectée au dispositif. L'application Web permet notamment à l'utilisateur d'interagir avec le dispositif, et de suivre l'estimation de la production de l'installation photovoltaïque.

L'invention vise aussi un programme informatique comportant des instructions pour la mise en oeuvre du procédé selon l'invention, lorsque ce programme est exécuté par un processeur.

D'autres caractéristiques et avantages de l'invention ressortiront de la description qui en est faite ci-après, en référence aux dessins dans lesquels :

- la figure 1 est une vue schématique du dispositif d'estimation d'une production d'une installation photovoltaïque selon un mode de réalisation de l'invention,
- la figure 2 illustre les principales étapes du procédé d'estimation d'une production d'une installation photovoltaïque selon un mode de réalisation de l'invention.

Ci-après un exposé détaillé de plusieurs modes de réalisation de l'invention assorti d'exemples et de référence aux dessins.

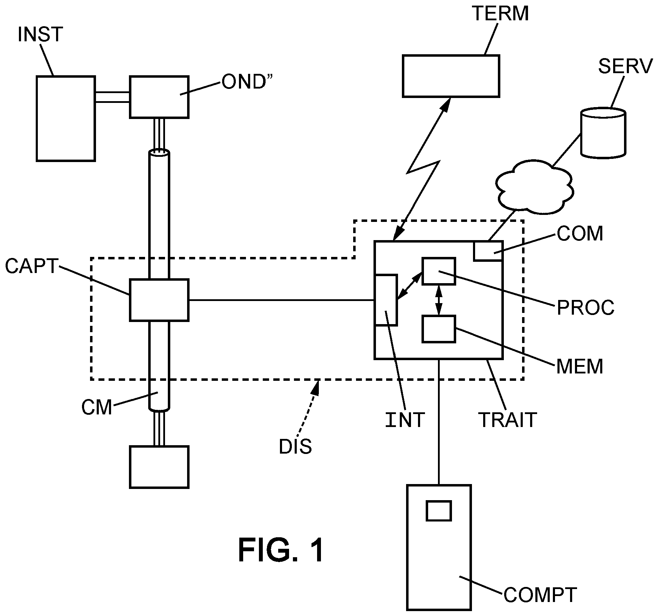

On se réfère tout d'abord à la figure 1 sur laquelle un exemple d'un dispositif d'estimation d'une production courante DIS d'une installation photovoltaïque INST selon l'invention est représenté.

L'installation photovoltaïque, ou installation, peut être une installation de toute taille. Par exemple, elle peut être une installation photovoltaïque prévue pour une autoconsommation et comprenant un nombre réduit de panneaux solaires photovoltaïques. Elle peut également être une installation importante de type centrale solaire de plusieurs mégawatts-crête.

Un onduleur OND est prévu pour permettre de fournir un courant alternatif à partir du courant généré par l'installation photovoltaïque. L'onduleur peut être un onduleur hybride, notamment dédié à l'autoconsommation, pour une installation photovoltaïque. Optionnellement, l'onduleur OND comprend une interface sur laquelle la production courante de l'installation INST à un instant donné est affichée. L'onduleur OND peut également permettre de raccorder l'installation photovoltaïque au réseau électrique.

Dans la suite de la description, les termes « production courante » ou « production » sont employés indifféremment.

Un capteur CAPT est en outre prévu. Le capteur CAPT permet d'estimer la production de l'installation photovoltaïque INST en sortie de l'onduleur OND. Le capteur CAPT est par exemple placé autour du câble multiconducteur CM en sortie de l'onduleur OND. Le câble multiconducteur CM comprend notamment au moins une phase, le neutre et la terre en sortie de l'installation photovoltaïque. En variante, et si l'onduleur et le réseau sont triphasés, le câble multiconducteur peut comprendre trois phases, le neutre et la terre en sortie de l'installation photovoltaïque. Le capteur CAPT est alors apte à mesurer un champ magnétique résultant du câble multiconducteur CM. Le capteur CAPT est par exemple de type capteur à effet Hall. L'installation du capteur CAPT autour du câble multiconducteur CM ne nécessite pas d'avoir des connaissances en électricité. En effet, l'installation du capteur CAPT se fait sans contact électrique direct, puisqu'il est installé directement autour du câble multiconducteur CM. Le capteur CAPT est par exemple fixé autour du câble multiconducteur CM par clipsage, par vissage, par des colliers de serrage ou par tout autre moyen de fixation.

Le capteur CAPT mesure le champ magnétique résultant autour du câble multiconducteur CM. Le champ magnétique résultant est proportionnel au courant transitant en sortie du câble multiconducteur CM. Le choix de mesurer le champ magnétique résultant est lié à la volonté de proposer un dispositif facile à installer par un utilisateur ne possédant pas de connaissance en électricité. Ce choix induit également que la valeur du courant transitant en sortie de l'onduleur n'est pas directement mesurable. Néanmoins, à partir de la mesure du champ magnétique résultant, il est possible de déterminer une valeur du signal utile en tension U en sortie du capteur, image du courant sortant de l'onduleur.

Par « utilisateur », on entend une personne consommant l'énergie produite par l'installation photovoltaïque. On peut également entendre une personne gérant la production de l'installation photovoltaïque.

Le dispositif DIS peut également comprendre un circuit de traitement TRAIT comprenant un processeur PROC et une interface de communication COM. Le capteur CAPT peut être connecté au circuit de traitement TRAIT au moyen d'une interface de connexion INT, de manière à communiquer les mesures du champ magnétique résultant pour traitement à un processeur PROC. Par exemple, le circuit de traitement TRAIT, et plus précisément le processeur PROC, est apte à déterminer la valeur du signal utile en tension U à partir de la mesure du champ magnétique résultant par le capteur CAPT. La connexion entre le circuit de traitement TRAIT et le capteur CAPT peut être une connexion sans-fil. Par exemple, la connexion est une connexion radio, internet, Wifi ou Bluetooth. En variante, la connexion est filaire. L'interface de communication COM permet par exemple d'envoyer des messages à l'utilisateur. Plus précisément, l'interface de communication COM est apte à communiquer l'estimation de la production de l'installation à l'utilisateur. Le circuit de traitement TRAIT peut en outre comprendre une mémoire MEM dans laquelle les mesures du champ magnétique résultant, le signal utile en tension U ou d'autres données décrites ci-après peuvent être stockées.

Le circuit de traitement TRAIT peut également être connecté à un serveur SERV. Le circuit de traitement TRAIT envoie par exemple des informations, telles que les données mesurées par le capteur CAPT, ou encore l'estimation de la production courante de l'installation, au serveur SERV. Les informations sont stockées sur le serveur SERV, et peuvent former une base de données. Les informations peuvent notamment être utilisées pour l'estimation de la production d'une autre installation photovoltaïque. La connexion entre le circuit de traitement TRAIT et le serveur SERV peut être une connexion sans-fil. Par exemple, la connexion est une connexion radio, internet, Wifi ou Bluetooth.

Un compteur électrique COMPT peut en outre être prévu. Le compteur électrique COMPT est relié à l'installation photovoltaïque et à le ou les utilisateur(s) de l'installation photovoltaïque. Le compteur électrique COMPT comprend notamment des informations sur la consommation d'énergie électrique d'un utilisateur. La consommation d'énergie électrique de l'utilisateur peut être mise en parallèle avec l'estimation de la production de l'installation photovoltaïque, comme décrit ci-après. Le compteur électrique COMPT peut être communiquant. Le compteur électrique COMPT peut être connecté au circuit de traitement TRAIT. Le compteur électrique COMPT peut notamment fournir des informations relatives à la consommation électrique d'un utilisateur au circuit de traitement TRAIT. La connexion entre le circuit de traitement TRAIT et le compteur électrique COMPT peut être une connexion sans-fil. Par exemple, la connexion est une connexion radio, internet, Wifi ou Bluetooth.

Le dispositif DIS peut en outre comprendre un terminal mobile TER, par exemple de type ordinateur, tablette, téléphone intelligent, ou encore un terminal de diagnostic dédié. Le terminal mobile comprend par exemple une application web dédiée, sur laquelle un utilisateur peut avoir accès à l'estimation de la production de l'installation photovoltaïque. L'utilisateur peut également avoir accès à des informations concernant la présence d'un éventuel défaut de l'installation photovoltaïque. En outre, l'utilisateur peut avoir accès à des informations concernant sa consommation d'énergie personnelle. Selon un exemple de réalisation, le terminal mobile TER et le circuit de traitement TER sont confondus.

Ainsi, l'utilisation du procédé au sens de l'invention est avantageuse dans le contexte de l'estimation de la production d'une installation photovoltaïque pour plusieurs raisons. Tout d'abord, le dispositif DIS permet à un utilisateur non familier avec les circuits électriques de placer lui-même le capteur CAPT sans danger. L'installation du capteur CAPT est particulièrement aisée. De plus, une fois que le capteur CAPT est installé, l'utilisateur a accès à l'estimation de la production courante de l'installation photovoltaïque à tout moment et à tout endroit. Cela est notamment rendu possible grâce à la connectivité du dispositif DIS.

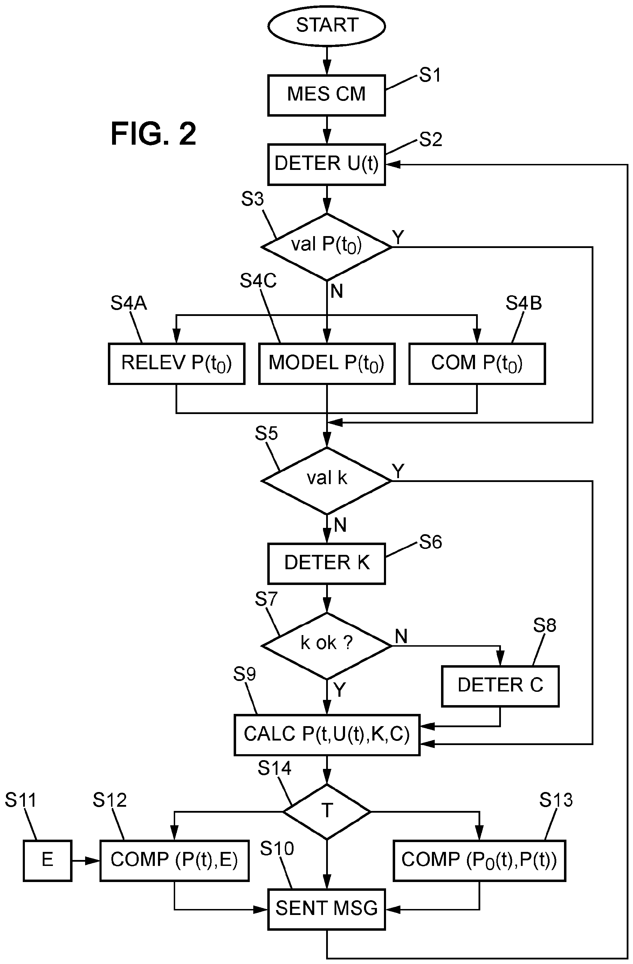

La figure 2 illustre les principales étapes du procédé de diagnostic au sens de l'invention.

Globalement, le procédé d'estimation de la production d'une installation photovoltaïque repose sur la mesure du champ magnétique résultant autour du câble multiconducteur CM en sortie de l'onduleur OND, ainsi que sur une méthode de calibrage. Le calibrage permet d'établir une corrélation entre le champ magnétique résultant mesuré et la production courante de l'installation photovoltaïque, qui ne sont pas directement corrélés entre eux.

Les étapes S1 à S4 correspondent à la calibration du dispositif. Les étapes S1 à S4 prennent place à un instant donné, appelé $t_0$. L'instant $t_0$ correspond par exemple à l'instant où l'utilisateur installe le capteur CAPT sur l'installation photovoltaïque. L'étape de calibration permet d'adapter le procédé à l'installation photovoltaïque sur laquelle le dispositif DIS est installé.

A l'étape S1, une mesure du champ magnétique résultant autour de l'onduleur OND est obtenue. Le champ magnétique est mesuré par le capteur CAPT. Le champ magnétique résultant est proportionnel au courant fourni par l'installation photovoltaïque INST en sortie de l'onduleur OND. Le champ magnétique résultant autour du câble multiconducteur CM dépend de la géométrie du câble multiconducteur CM, par exemple de la forme de sa section, ainsi que de l'emplacement du capteur CAPT autour du câble multiconducteur CM. La mesure du champ magnétique résultant autour du câble multiconducteur CM, correspond au champ magnétique résultant autour de la phase, du neutre et de la terre, compris dans le câble multiconducteur. Il n'est donc pas possible de déterminer directement le courant transitant dans l'installation photovoltaïque INST à partir du champ magnétique résultant autour du câble multiconducteur CM.

En revanche, la valeur du signal utile en tension U(t) produite par l'installation photovoltaïque INST peut être déterminée à l'étape S2. En effet, le champ magnétique résultant est proportionnel au courant fourni par l'installation photovoltaïque INST, lui-même proportionnel à la tension fournie par l'installation photovoltaïque INST. Le signal utile en tension U(t) peut ensuite être communiqué au circuit de traitement TRAIT. Durant la calibration, le signal utile en tension U(t) est le signal utile en tension U(t=$t_0$), obtenu à l'instant donné $t_0$.

L'étape suivante comprend la détermination de la production courante de référence P($t_0$) de l'installation photovoltaïque INST à un instant donné $t_0$.

L'étape S3 consiste à déterminer si la production courante de référence P($t_0$) de l'installation photovoltaïque est déjà connue. Si la production courante de référence P($t_0$) de l'installation photovoltaïque est connue, le procédé continue directement à l'étape S5. Si la production courante de référence P($t_0$) de l'installation photovoltaïque n'est pas connue, la production de référence P($t_0$) de l'installation photovoltaïque est déterminée aux étapes S4A à S4C.

A l'étape S4A, la valeur de la production courante de référence P($t_0$) est par exemple obtenue par un relevé de la valeur de la production sur l'onduleur OND par un utilisateur à l'instant $t_0$. En effet, sur certains onduleurs, la production de l'installation photovoltaïque peut être directement accessible via un compteur prévu sur l'onduleur. L'utilisateur entre alors la valeur de la production courante de référence P($t_0$) relevée sur l'onduleur OND via l'interface de communication COM à l'instant $t_0$. En variante, l'utilisateur peut entrer la valeur de la production courante de référence P($t_0$) via le terminal mobile TER.

A l'étape S4B, la valeur de la production courante de référence P($t_0$) peut être obtenue au moyen du compteur communiquant COM. En effet, le compteur communiquant COM dispose d'informations mesurées en temps réel à l'instant $t_0$. Le compteur communiquant COM envoie par exemple des informations permettant de déterminer la production courante de référence P($t_0$) via l'interface de communication COM ou via le terminal mobile TER. Les informations comprennent notamment, à l'instant donné $t_0$, la puissance consommée par l'utilisateur, la puissance injectée dans le réseau, la tension du réseau etc.

La valeur de la production courante de référence P($t_0$) peut également être obtenue par une modélisation de l'installation photovoltaïque, tel qu'illustrée à l'étape S4C. Par exemple, l'utilisateur entre des caractéristiques relatives à l'installation photovoltaïque INST via l'interface de communication COM ou via le terminal mobile TER. Les caractéristiques peuvent comprendre la puissance-crête de l'installation, l'inclinaison, l'orientation, le mode de pose, le risque d'ombrage, le type de panneau des modules photovoltaïques de l'installation photovoltaïque, ou encore la marque ou le modèle de l'onduleur OND. Ces caractéristiques peuvent en outre permettre de déterminer directement la valeur d'un coefficient, appelé coefficient de mise à l'échelle $k$. Le coefficient de mise à l'échelle $k$ permet de corréler la production courante P avec le signal utile en tension U. Si la production courante de référence P($t_0$) a été obtenue à l'étape S4C, les étapes du procédé S5 à S8 peuvent ne pas être mises en oeuvre.

Les étapes S5 à S8 comprennent la détermination du coefficient de mise à l'échelle k. L'étape S5 réside à vérifier si le coefficient de mise à l'échelle $k$ est déjà connu. Si tel est le cas, les étapes S6 à S8 peuvent ne pas être mises en oeuvre. La prochaine étape mise en oeuvre est l'étape S9.

Si le coefficient de mise à l'échelle $k$ n'est pas connu, le coefficient de mise à l'échelle $k$ peut être déterminé à l'étape S6. Plus particulièrement, le coefficient de mise à l'échelle $k$ peut être déterminé par la formule suivante :

$$P(t_0) = k \ x \ U(t=t_0)$$

Le coefficient de mise à l'échelle $k$ fait le lien entre la production courante de référence $P(t_0)$ réellement produite par l'installation photovoltaïque à l'instant $t_0$ et le signal utile en tension $U(t=t_0)$ obtenu par la mesure du champ magnétique résultant mesuré par le capteur CAPT à l'instant $t_0$.

L'étape S7 comprend la vérification du coefficient de mise à l'échelle $k$. En effet, il est possible que, lors de la mesure du champ magnétique résultant, la valeur en sortie du capteur CAPT subisse un décalage avec la valeur réelle du champ magnétique résultant. Ainsi, il est possible que le signal utile en tension $U$, obtenu à partir de la mesure du champ magnétique résultant, ait subi un décalage également. Le coefficient de mise à l'échelle $k$ peut ainsi ne pas être correct. Afin de déterminer si le coefficient de mise à l'échelle $k$ est correct, il est possible d'effectuer une estimation de la production $P(t)$ de l'installation photovoltaïque lorsque la production $P(t)$ est censée être nulle. Cela peut notamment être fait la nuit, ou en dehors des périodes de production solaire. Si la production $P(t)$ n'est pas égale à zéro, alors qu'elle le devrait, il est déterminé que le coefficient de mise à l'échelle $k$ n'est pas correct.

Si tel est le cas, une correction est réalisée à l'étape S8. Le coefficient de mise à l'échelle $k$ est par exemple corrigé de manière à compenser le décalage détecté à l'étape S7. Plus précisément, la valeur du décalage est la valeur de la production $P(t)$ lorsque la valeur de la production $P(t)$ devrait être égale à zéro. La formule permettant de corréler le signal en tension utile $U(t)$ à la production $P(t)$ devient alors :

$$P(t) = k \ x \ U(t) + c$$

Avec, c égal à l'opposé du décalage déterminé à l'étape S8, ou c égal à zéro si aucun décalage n'a été détecté à l'étape S7. La calibration permet donc d'obtenir le signal utile en tension $U(t=t_0)$ en sortie de l'onduleur OND de l'installation photovoltaïque INST, la production de référence $P(t_0)$ de l'installation photovoltaïque INST, et à partir de ces données, le coefficient de mise à l'échelle $k$ et le décalage $c$. Le coefficient de mise à l'échelle $k$ et le décalage c sont ensuite conservés en mémoire pour être utilisés pour l'estimation la production $P(t)$ de l'installation photovoltaïque INST à chaque instant $t$. Le coefficient de mise à l'échelle $k$ et le décalage c sont constants pour chaque installation photovoltaïque. Toutefois, si le capteur CAPT est déplacé, le coefficient de mise à l'échelle $k$ et le décalage c doivent être recalculés. En effet, le champ magnétique résultant mesuré dépend de l'emplacement du capteur CAPT et de la géométrie du câble conducteur CM à cet emplacement.

A chaque instant $t$, le signal utile en tension $U(t)$ est obtenu par une mesure du champ magnétique résultant par le capteur CAPT. Le signal utile en tension $U(t)$ est injecté dans l'équation définie ci-avant pour obtenir l'estimation de la production $P(t)$ à chaque instant $t$. Cela correspond à l'étape S9.

A l'étape S10, le dispositif peut envoyer un message à l'utilisateur, par exemple via l'interface de communication COM ou encore via le terminal mobile TER. Le message peut comprendre l'estimation de la production $P(t)$ à chaque instant $t$. En variante, l'utilisateur peut par exemple prédéterminer le moment d'envoi d'un tel message. Par exemple, l'utilisateur peut choisir de recevoir l'estimation de la production $P(t)$ toutes les heures, ou une fois par jour. En variante, il est possible de choisir un intervalle de temps entre chaque estimation de la production $P(t)$ de l'installation photovoltaïque. Par exemple, il est possible de programmer une estimation toutes les trois minutes, ou encore toutes les heures, voire une fois par jour. Le capteur CAPT effectue alors une mesure du champ magnétique résultant à chaque intervalle de temps déterminé.

En variante, et antérieurement à l'étape S10, la puissance électrique consommée par l'utilisateur peut être obtenue à l'étape S11. La puissance électrique est par exemple transmise par le compteur communiquant COMPT au circuit de traitement TRAIT.

Une comparaison entre la puissance électrique consommée par l'utilisateur à un instant donné et l'estimation de la production $P(t)$ au même instant peut être effectuée à l'étape S12. Le résultat de cette comparaison peut ensuite être envoyé à l'utilisateur à l'étape S10, via l'interface de communication COM ou via le terminal mobile TERM. Il est en outre possible de générer des messages personnalisés à l'utilisateur en fonction du résultat de la comparaison. Par exemple, si la puissance consommée par l'utilisateur est plus importante que la production $P(t)$ de l'installation photovoltaïque, un message d'avertissement peut être envoyé. Des conseils de régulation de consommation électrique peuvent également être générés. Par exemple, l'utilisateur peut recevoir un message indiquant à quelles heures mettre en marche une machine à laver, un chauffe-eau électrique, ou un système de climatisation pour réguler sa consommation d'électricité.

En variante, une comparaison entre la production $P(t)$ et la production de référence $P(t_0)$ peut être effectuée à l'étape S13. L'étape S13 est effectuée antérieurement à l'étape S10 et peut être indépendante des étapes S 11 et S12. La comparaison entre la production $P(t)$ et la production de référence $P(t_0)$ peut notamment permettre de détecter la présence d'un défaut de l'installation photovoltaïque. Par exemple, si la variation entre la production $P(t)$ et la production de référence $P(t_0)$ est supérieure à un seuil choisi, la présence d'un défaut de l'installation photovoltaïque est détectée. Un message de présence de défaut peut alors être transmis à l'utilisateur à l'étape S10. Le message est par exemple transmis via l'interface de communication COM ou via le terminal mobile TERM.

En variante, il est possible de mettre en oeuvre les étapes S9, S12 et S13, et recevoir un message à l'étape S10 relativement aux résultats obtenus aux étapes S9, 12 et 13.

En variante, une étape de teste S14 peut être mise en oeuvre antérieurement aux étapes S9, S12 et S13. Par exemple, à l'étape S14, une proposition pour mettre en oeuvre une interrogation de la mémoire MEM ou du serveur SERV peut être générée. L'interrogation peut permettre de vérifier si un défaut de l'installation a déjà été détecté dans le passé. L'utilisateur peut alors choisir s'il souhaite mettre en oeuvre l'étape S13 de vérification de présence d'un défaut de l'installation. En alternative, selon les résultats de l'interrogation, le dispositif peut choisir de mettre en oeuvre ou non l'étape S14. Par exemple, si un défaut a été détecté, l'étape S14 est mise en oeuvre par le dispositif.

De même, une proposition pour mettre en oeuvre une interrogation de la mémoire MEM ou du serveur SERV peut être générée à l'étape S14 pour déterminer si l'étape S12 est mise en oeuvre. Par exemple, le dispositif détermine que l'utilisateur pratique l'autoconsommation et met alors en oeuvre l'étape S12. En variante, l'utilisateur a par exemple précisé qu'il souhaite effectuer une comparaison entre la puissance électrique qu'il a consommée et la production courante de l'installation. Cette information est stockée en mémoire MEM ou dans le serveur SERV. L'information est retrouvée lors de l'étape S14.

**Revendications**

1. Procédé, mis en oeuvre par des moyens informatiques, d'estimation d'une production (P) d'une installation photovoltaïque (INST) par une mesure d'un champ magnétique résultant d'un câble multiconducteur (CM) en sortie d'un onduleur (OND) de l'installation photovoltaïque (INST) au moyen d'un capteur (CAPT) de type à effet Hall, le procédé comprenant :

   - une calibration comportant :

     ∘ une détermination d'un signal utile en tension $(U(t=t_0))$ en sortie de l'installation photovoltaïque (INST) à partir de la mesure du champ magnétique résultant à un instant donné $(t_0)$,
     ∘ une obtention d'une production courante de référence $(P(t_0))$ de l'installation photovoltaïque au même instant donné $(t_0)$,
     ∘ une détermination d'un coefficient de mise à l'échelle (k) mettant en relation le signal utile en tension $(U(t=t_0))$ et la production de référence $(P(t_0))$ de l'installation photovoltaïque (INST), le coefficient de mise à l'échelle (k) étant stocké dans une mémoire (MEM),

   - puis, l'estimation, à chaque instant (t), d'une production courante (P(t)) de l'installation photovoltaïque (INST) à partir du signal utile en tension (U(t)) en sortie de l'installation photovoltaïque (INST) déterminée à chaque instant (t), et du coefficient de mise à l'échelle (k) stocké en mémoire (MEM).

2. Procédé selon la revendication 1, dans lequel la calibration comporte en outre une vérification du coefficient de mise à l'échelle (k), et, le cas échéant, une correction du coefficient de mise à l'échelle.

3. Procédé selon l'une des revendications 1 et 2, dans lequel, lors de la calibration, la production courante de référence $(P(t_0))$ de l'installation photovoltaïque (INST) à l'instant donné $(t_0)$ est obtenue par un relevé d'une valeur de la production courante de référence $(P(t_0))$ sur l'onduleur (OND) par un utilisateur à l'instant donné $(t_0)$, la valeur étant saisie par l'utilisateur via une interface de communication (COM, TER) connectée aux moyens informatiques.

4. Procédé selon l'une des revendications 1 et 2, dans lequel, lors de la calibration, la production courante de référence $(P(t_0))$ de l'installation photovoltaïque (INST) à l'instant donné $(t_0)$ est obtenue par une modélisation de l'installation photovoltaïque (INST) à partir de données relatives à l'installation photovoltaïque (INST), les données étant saisies par un utilisateur via une interface de communication (COM, TER) connectée aux moyens informatiques.

5. Procédé selon l'une des revendications 1 et 2, dans lequel, lors de la calibration, la production courante de référence $(P(t_0))$ de l'installation photovoltaïque (INST) à l'instant donné est obtenue au moyen d'un compteur électrique communicant (COMPT) connecté aux moyens informatiques.

6. Procédé selon l'une des revendications 1 à 5, dans lequel la production courante (P(t)) de l'installation photovoltaïque (INST) est, à chaque instant (t), communiquée à un utilisateur au moyen d'une interface de communication (COM, TER) connectée aux moyens informatiques.

7. Procédé selon l'une des revendications 1 à 6, comprenant en outre une détermination de présence d'un défaut de l'installation photovoltaïque par une comparaison entre la production courante de référence $(P(t_0))$ et la production courante (P(t)) de l'installation photovoltaïque (INST).

8. Procédé selon l'une des revendications 1 à 7, comprenant en outre une détermination d'une variation entre une consommation électrique d'un utilisateur de l'installation photovoltaïque (INST) et la production courante (P(t)) de l'installation photovoltaïque (INST), en cas de variation, l'émission d'un message à l'utilisateur au moyen d'une interface de communication (COM, TER) connectée aux moyens informatiques.

9. Dispositif d'estimation d'une production d'une installation photovoltaïque (INST) par une mesure d'un champ magnétique résultant d'un câble multiconducteur (CM) en sortie d'un onduleur (OND) de l'installation photovoltaïque (INST), au moyen d'un capteur (CAPT) de type à effet Hall le dispositif comprenant :

   - un circuit de traitement (TRAIT) configuré pour la mise en oeuvre du procédé selon l'une des revendications 1 à 8.

10. Dispositif selon la revendication 9, comprenant en outre une interface de communication (COM, TER), reliée au circuit de traitement de manière sans-fil.

11. Programme informatique **caractérisé en ce qu'**il comporte des instructions pour la mise en oeuvre du procédé selon l'une des revendications 1 à 8, lorsque ce programme est exécuté par un processeur.


**Patentansprüche**

1. Verfahren zur Schätzung einer Produktion (P) einer Photovoltaikanlage (INST) durch eine Messung eines magnetischen Feldes, das aus einem mehradrigen Kabel (CM) am Ausgang eines Wechselrichters (OND) der Photovoltaikanlage (INST) resultiert, mittels eines Sensors (CAPT) vom Typ Hall-Effekt, wobei das Verfahren umfasst:

   - eine Kalibrierung, umfassend:

      • eine Bestimmung eines nutzbaren Spannungssignals ($U(t=t_0)$) am Ausgang der Photovoltaikanlage (INST) aus der Messung des resultierenden magnetischen Feldes zu einem gegebenen Zeitpunkt ($t_0$),
      • eine Ermittlung einer aktuellen Referenzproduktion ($P(t_0)$) der Photovoltaikanlage zum selben Zeitpunkt ($t_0$),
      • eine Bestimmung eines Skalierungskoeffizienten (k), der das Spannungsnutzsignal ($U(t=t_0)$) und die Referenzproduktion ($P(t_0)$) der Photovoltaikanlage (INST) in Beziehung zueinander setzt, wobei der Skalierungskoeffizient (k) in einem Speicher (MEM) gespeichert wird,

      - dann, zu jedem Zeitpunkt (t), Schätzen einer aktuellen Produktion (P(t)) der Photovoltaikanlage (INST) aus dem zu jedem Zeitpunkt (t) bestimmten nutzbaren Spannungssignal (U(t)) am Ausgang der Photovoltaikanlage (INST) und dem in einem Speicher (MEM) gespeicherten Skalierungskoeffizienten (k).

2. Verfahren nach Anspruch 1, wobei die Kalibrierung ferner eine Überprüfung des Skalierungskoeffizienten (k) und gegebenenfalls eine Korrektur des Skalierungskoeffizienten umfasst.

3. Verfahren nach einem der Ansprüche 1 und 2, wobei während der Kalibrierung die aktuelle Referenzproduktion ($P(t_0)$) der Photovoltaikanlage (INST) zum gegebenen Zeitpunkt ($t_0$) durch Ablesen eines Wertes der aktuellen Referenzproduktion ($P(t_0)$) am Wechselrichter (OND) durch einen Benutzer zum gegebenen Zeitpunkt ($t_0$) erhalten wird, wobei der Wert vom Benutzer über eine Kommunikationsschnittstelle (COM, TER) eingegeben wird, die mit den Computermitteln verbunden ist.

4. Verfahren nach einem der Ansprüche 1 und 2, wobei während der Kalibrierung die aktuelle Referenzproduktion ($P(t_0)$) der Photovoltaikanlage (INST) zum gegebenen Zeitpunkt ($t_0$) durch eine Modellierung der Photovoltaikanlage (INST) anhand von Daten bezüglich der Photovoltaikanlage (INST) erhalten wird, wobei die Daten von einem Benutzer über eine Kommunikationsschnittstelle (COM, TER) erfasst werden, die mit den Computermitteln verbunden ist.

5. Verfahren nach einem der Ansprüche 1 und 2, wobei bei der Kalibrierung die aktuelle Referenzproduktion ($P(t_0)$) der Photovoltaikanlage (INST) zum gegebenen Zeitpunkt mittels eines kommunizierenden Stromzählers (COMPT), der mit den Computermitteln verbunden ist, ermittelt wird.

6. Verfahren nach einem der Ansprüche 1 bis 5, wobei die aktuelle Produktion (P(t)) der Photovoltaikanlage (INST) einem Benutzer zu jedem Zeitpunkt (t) mittels einer Kommunikationsschnittstelle (COM, TER), die mit den Computermitteln verbunden ist, mitgeteilt wird.

7. Verfahren nach einem der Ansprüche 1 bis 6, ferner umfassend eine Bestimmung des Vorhandenseins eines Fehlers der Photovoltaikanlage durch einen Vergleich zwischen der aktuellen Referenzproduktion ($P(t_0)$) und der aktuellen Produktion (P(t)) der Photovoltaikanlage (INST).

8. Verfahren nach einem der Ansprüche 1 bis 7, ferner umfassend eine Bestimmung einer Abweichung zwischen einem Stromverbrauch eines Benutzers der Photovoltaikanlage (INST) und der aktuellen Produktion (P(t)) der Photovoltaikanlage (INST), im Falle einer Abweichung Übermittlung einer Nachricht an den Benutzer mittels einer Kommunikationsschnittstelle (COM, TER), die mit den Computermitteln verbunden ist.

9. Vorrichtung zur Schätzung einer Produktion einer Photovoltaikanlage (INST) durch Messung eines Magnetfelds, das aus einem mehradrigen Kabel (CM) am Ausgang eines Wechselrichters (OND) der Photovoltaikanlage (INST) resultiert, mittels eines Sensors (CAPT) vom Typ Hall-Effekt, wobei die Vorrichtung umfasst: eine Verarbeitungsschaltung (TRAIT), die für die Durchführung des Verfahrens nach einem der Ansprüche 1 bis 8 konfiguriert ist.

10. Vorrichtung nach Anspruch 9, welche ferner eine Kommunikationsschnittstelle (COM, TER) umfasst, die drahtlos mit der Verarbeitungsschaltung verbunden ist.

11. Computerprogramm, **dadurch gekennzeichnet, dass** es Anweisungen zur Durchführung des Verfahrens nach einem der Ansprüche 1 bis 8 enthält, wenn dieses Programm von einem Prozessor ausgeführt wird.

## Claims

1. A method, implemented by computer means, for estimating a production (P) of a photovoltaic plant (INST) by measuring a magnetic field resulting from a multi-conductor cable (CM) at the output of an inverter (OND) of the photovoltaic plant (INST) by means of a Hall effect type sensor (CAPT), the method comprising:

    - a calibration including:

        o determining a useful voltage signal $(U(t=t_0))$ at the output of the photovoltaic plant (INST) from the measurement of the resulting magnetic field at a given time point $(t_0)$,
        ∘ obtaining a reference current production $(P(t_0))$ of the photovoltaic plant at the same given time point $(t_0)$,
        ∘ determining a scaling coefficient (k) relating the useful voltage signal $(U(t=t_0))$ and the reference production $(P(t_0))$ of the photovoltaic plant (INST), the scaling coefficient (k) being stored in a memory (MEM),

    - then, the estimation, at each time point (t), of a current production (P(t)) of the photovoltaic plant (INST) from the useful voltage signal (U(t)) at the output of the photovoltaic plant (INST) determined at each time point (t), and from the scaling coefficient (k) stored in memory (MEM).

2. The method according to claim 1, wherein the calibration further includes a verification of the scaling coefficient (k), and, where appropriate, a correction of the scaling coefficient.

3. The method according to one of claims 1 and 2, wherein, during the calibration, the reference current production $(P(t_0))$ of the photovoltaic plant (INST) at the given time point $(t_0)$ is obtained by reading a value of the reference current production $(P(t_0))$ on the inverter (OND) by a user at the given time point $(t_0)$, the value being entered by the user via a communication interface (COM, TER) connected to the computer means.

4. The method according to one of claims 1 and 2, wherein, during the calibration, the reference current production $(P(t_0))$ of the photovoltaic plant (INST) at the given time point $(t_0)$ is obtained by modelling the photovoltaic plant (INST) on the basis of data relating to the photovoltaic plant (INST), the data being entered by a user via a communication interface (COM, TER) connected to the computer means.

5. The method according to one of claims 1 and 2, wherein, during the calibration, the reference current production $(P(t_0))$ of the photovoltaic plant (INST) at the given time point is obtained by means of a communicating electricity meter (COMPT) connected to computer means.

6. The method according to one of claims 1 to 5, wherein the current production (P(t)) of the photovoltaic plant (INST) is, at each time point (t), communicated to a user by means of a communication interface (COM, TER) connected to the computer means.

7. The method according to one of claims 1 to 6, further comprising a determination of the presence of a fault in the photovoltaic plant by comparison between the reference current production $(P(t_0))$ and the current production (P(t)) of the photovoltaic plant (INST).

8. The method according to one of claims 1 to 7, further comprising a determination of a variation between an electricity consumption of a user of the photovoltaic plant (INST) and the current production (P(t)) of the photovoltaic plant (INST), in case of variation, sending a message to the user by means of a communication interface (COM, TER) connected to the computer means.

9.  A device for estimating a production of a photovoltaic plant (INST) by measuring a magnetic field resulting from a multi-conductor cable (CM) at the output of an inverter (OND) of the photovoltaic plant (INST), by means of a Hall effect type sensor (CAPT), the device comprising:

    - a processing circuit (TRAIT) configured for the implementation of the method according to one of claims 1 to 8.

10. The device according to claim 9, further comprising a communication interface (COM, TER), wirelessly connected to the processing circuit.

11. A computer program **characterised in that** it includes instructions for implementing the method according to one of claims 1 to 8, when this program is executed by a processor.

INST

OND"

TERM

SERV

COM

CAPT

PROC

MEM

CM

INT

TRAIT

DIS

FIG. 1

COMPT

# FIG. 2

**EP 3 502 716 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2017090004 A1
- WO 2017152243 A1